# FASCICULE DE BREVET EUROPEEN

(11) **EP 2 439 583 B1**
(45) Date de publication et mention de la délivrance du brevet: **08.04.2015**
(21) Numéro de dépôt: 11183971.8
(22) Date de dépôt: 05.10.2011
(51) Int. Cl.: G02F 1/1362, H01L 23/64, H01L 23/522, H01G 4/30, H01L 21/02

(54) **Afficheur a cristal liquide de type transmissif en technologie CMOS avec capacité de stockage auxiliaire**
Flüssigkristallanzeige vom transmissiven Typ in CMOS-Technologie mit zusätzlicher Speicherkapazität
Transmissive liquid crystal display using CMOS technology with auxiliary storage capacity

(30) Priorité: 08.10.2010 FR 1003996
(43) Date de publication de la demande: 11.04.2012
(73) Titulaire: Commissariat à l'Énergie Atomique et aux Énergies Alternatives, 75015 Paris (FR)
(72) Inventeur: Segura Puchades, Josep, 38600 FONTAINE (FR)
(74) Mandataire: Guérin, Michel

(56) Documents cités:
- WO-A1-01/07961
- JP-A- 2003 297 930
- JP-A- 2009 135 149
- US-A1- 2004 119 899
- US-A1- 2004 257 489
- US-A1- 2006 024 905
- US-A1- 2007 181 918

## Description

L'invention concerne l'affichage d'images par un afficheur à cristaux liquides à matrice active. Elle s'applique plus particulièrement aux écrans de petites dimensions, réalisés sur substrats de silicium monocristallin (technologie LCOS de l'anglais "Liquid Crystal on Silicon") et qui sont de type transmissifs.

Un afficheur à matrice active comprend une matrice de lignes et colonnes de pixels, chaque pixel comportant un cristal liquide entre une électrode de pixel et une contre-électrode commune à tous les pixels. La tension appliquée entre l'électrode de pixel et l'électrode commune produit un champ électrique qui oriente les molécules du cristal liquide en fonction du module du champ. Cette orientation agit sur la polarisation de la lumière qui traverse le cristal de manière à définir, en combinaison avec l'usage de polariseurs, un niveau de transmission de lumière qui dépend du champ électrique appliqué. Un transistor de commande (l'élément actif du pixel) relie l'électrode de pixel de tous les pixels d'une même colonne à un conducteur de colonne respectif. Le conducteur de colonne reçoit à un moment donné une tension analogique définissant un niveau de gris à appliquer au pixel ; si le transistor est conducteur, cette tension est appliquée à l'électrode de pixel ; sinon, le pixel se comporte comme une capacité isolée et conserve le niveau de tension reçu précédemment. Les transistors de commande d'une même ligne de pixels sont commandés par un conducteur de ligne respectif ; ainsi, pendant l'écriture d'une trame d'image, on adresse successivement les différentes lignes de la matrice pour écrire à un instant donné dans les pixels de la ligne adressée l'information appliquée à cet instant par les conducteurs de colonne.

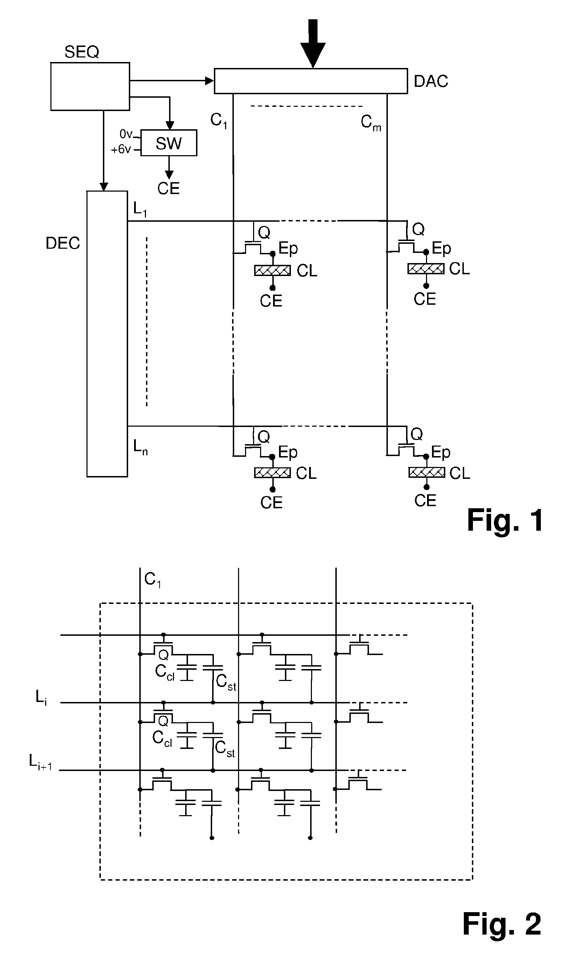

La figure 1 représente la structure générale d'une telle matrice, où CL désigne une cellule à cristal liquide et Q désigne le transistor associé à cette cellule, l'ensemble de la cellule et du transistor formant le pixel. La contre-électrode commune est désignée par CE, l'électrode du pixel est désignée par Ep. Les conducteurs de commande en ligne sont désignés par L1 à Ln pour une matrice de n lignes. Les conducteurs de colonne sont C1 à Cm pour une matrice de m colonnes. Un décodeur de ligne DEC adresse successivement les différentes lignes. Un circuit de conversion numérique- analogique DAC applique aux conducteurs de colonne pendant l'adressage d'une ligne un ensemble de tensions analogiques représentant l'image à afficher par cette ligne. Le circuit de conversion établit ces tensions analogiques à partir d'un signal numérique. Un circuit de séquencement SEQ assure le fonctionnement synchronisé du décodeur de ligne et du circuit de conversion DAC.

D'autres éléments de circuits peuvent être présents, tels qu'un circuit d'inversion périodique de polarité de la contre-électrode. Ils ne sont pas représentés.

Le cristal liquide entre deux électrodes se comporte comme une capacité. C'est ce comportement capacitif qui permet de maintenir à ses bornes la tension qui lui a été appliquée pendant l'écriture de la ligne correspondante. Mais cette capacité a une faible valeur et on souhaite en général la compléter par une capacité de stockage auxiliaire.

En effet, le courant de fuite du transistor de commande entraîne la perte de charge stockée dans la capacité du pixel, ce qui implique une variation de la tension entre les électrodes du cristal liquide. Par ailleurs, la capacité du cristal liquide varie également au fur et à mesure que le cristal liquide prend l'orientation moléculaire qui lui est conférée en fonction de la tension appliquée.

Cette capacité de stockage auxiliaire est connectée en principe en parallèle avec les électrodes du cristal liquide puisqu'elle a pour vocation de renforcer la valeur de la capacité propre du cristal liquide.

Cependant, comme les capacités en jeu sont relativement faibles, on a constaté que la capacité grille-source du transistor de commande Q n'était pas négligeable et induisait une modification indésirable de la tension aux bornes du cristal liquide au moment de l'interruption de l'application de la tension d'écriture. En effet, la tension d'écriture est appliquée par une impulsion de commande sur la grille des transistors Q d'une ligne déterminée ; cette impulsion reporte sur la source du transistor la valeur de tension d'écriture désirée, de sorte que la capacité du cristal liquide et la capacité de stockage auxiliaire se chargent avec cette valeur ; mais lorsque l'impulsion sur la grille se termine, ces deux capacités se déchargent partiellement dans la capacité grille-source du transistor, en proportion de la valeur de cette capacité ; la tension qui persiste alors sur le cristal liquide n'est plus exactement celle qu'on voulait.

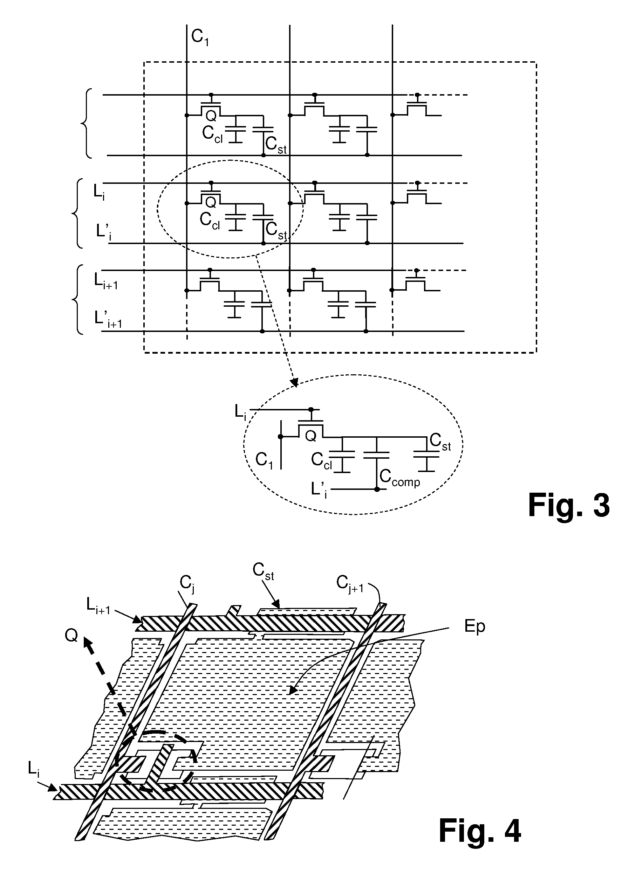

Pour remédier à ce phénomène, on peut envisager les solutions suivantes :
- connecter la capacité de stockage auxiliaire non pas entre l'électrode Ep du cristal liquide et la contre-électrode CE, mais entre l'électrode Ep et le conducteur de commande de la ligne suivante ; la figure 2 représente le schéma électrique correspondant, où l'on voit pour chaque pixel un transistor Q, la capacité C_{cl} du cristal liquide de ce pixel, la capacité de stockage auxiliaire Cₛ, celle-ci étant reliée entre l'électrode du pixel (elle-même reliée à la source du transistor Q correspondant) et le conducteur de commande de la ligne suivante Lᵢ₊₁ ; la perte de tension aux bornes du cristal liquide au moment de la fin de l'impulsion (front descendant) de mise en conduction du transistor de commande est compensée par une augmentation de tension correspondante au moment du début (front montant) de l'impulsion de mise en conduction des transistors de la ligne suivante ; cette compensation est efficace si la valeur de la capacité de stockage auxiliaire est égale à la valeur de la capacité grille-source du transistor de commande ;
- connecter la capacité de stockage auxiliaire, ou une capacité de compensation supplémentaire, à un conducteur de ligne auxiliaire, commun à tous les pixels de la ligne, fournissant une impulsion de compensation, d'amplitude ajustable, synchronisée avec l'impulsion de commande d'écriture et de sens contraire de celle-ci ; ainsi, lorsque le front descendant de l'impulsion de commande d'écriture tend à provoquer une diminution de tension sur l'électrode de pixel, le front montant de l'impulsion de compensation tend à provoquer une augmentation de cette tension, en proportion de l'amplitude de l'impulsion de compensation ; en ajustant le niveau d'amplitude de l'impulsion de compensation on peut compenser l'influence de la fin de l'impulsion de commande d'écriture ; la figure 3 fait apparaître que chaque pixel est alors commandé par deux conducteurs de ligne, respectivement Lᵢ et L'ᵢ pour la ligne de rang i ; le deuxième conducteur de ligne L'ᵢ est relié à la deuxième borne de la capacité de stockage Cₛ, la première borne étant reliée à l'électrode de pixel du cristal liquide et à la source du transistor Q ; tous les pixels de la ligne sont connectés de cette manière au conducteur L'; ; alternativement on peut prévoir qu'il y a à la fois une capacité de stockage auxiliaire Cst simplement en parallèle avec le cristal liquide et une capacité de compensation Ccomp ; la capacité de compensation est alors reliée entre l'électrode de pixel et le conducteur de ligne L'ᵢ. Ces deux solutions sont représentées sur la figure 3.

Dans tous les cas, on a donc besoin de prévoir au moins une capacité (capacité de stockage auxiliaire et/ou capacité de compensation) dans le pixel.

Dans les technologies d'afficheurs à matrice active sur panneaux de verre, dans lesquelles les transistors sont en silicium amorphe, on réalise le plus souvent le pixel avec une configuration telle que celle qui est représentée à la figure 4. Le pixel est rectangulaire ou carré et occupe une surface entre deux conducteurs de ligne successifs L et Li+1 et deux conducteurs de colonne successifs Cj et Cj+1 L'électrode de pixel

Ep, transparente, occupe la majeure partie de ce rectangle, et un coin du rectangle est occupé par le transistor Q en silicium amorphe dont la grille est reliée au conducteur de ligne L, la source est reliée à l'électrode Ep, et le drain est relié au conducteur de colonne Cj.

La capacité de stockage auxiliaire Cs est dans ce cas tout simplement constituée par une extension latérale de l'électrode de pixel Ep et par le conducteur de ligne suivant L;+1 qui passe au-dessus de cette extension et qui en est séparé par une couche isolante. C'est la configuration de la figure 2 adaptée à la technologie du silicium amorphe. L'électrode de pixel est en oxyde d'indium étain (ITO) qui a la propriété d'être transparent.

Ce type de structure de pixel est utilisable dans des afficheurs de type transmissif à matrice de transistors en silicium amorphe.

Des autres modes de réalisation des capacités de stockage auxiliaire dans des afficheurs aux cristaux liquides, servant à masquer le transistor de la lumière, sont divulgués dans les documents de l'art antérieur US2004/257489 et US2004/119899. Des capacités pour des circuits intégrés basées sur des structures à armatures interdigitées superposées et mises en parallèle (et placées au-dessus des composants électroniques pour limiter l'espace occupé) sont divulguées dans les documents JP2009/135149, JP2003/297930, US2006/024905, US 2007/181918. Les afficheurs de petite dimension réalisés en technologie LCOS, c'est-à-dire sur substrat de silicium monocristallin, sont en général de type réflectif, de sorte que l'électrode Ep

du pixel n'est pas transparente mais réfléchissante. Cette électrode n'est pas disposée latéralement à côté du transistor de commande Q comme pour les afficheurs en silicium amorphe tel que celui de la figure 4, mais elle recouvre complètement le transistor ; le transistor est naturellement protégé de la lumière par l'électrode du pixel.

Si on veut faire un afficheur en technologie LCOS qui soit de type transmissif, l'électrode du pixel ne peut plus être en métal réfléchissant car elle empêcherait le passage de la lumière : dans un afficheur transmissif la lumière issue d'une source de lumière traverse une seule fois le cristal liquide et les couches de circuits électroniques servant à commander les pixels, avant d'être observée ou projetée sur un écran, alors que dans un afficheur réflectif, elle traverse une première fois le cristal liquide, elle se réfléchit sur une électrode réfléchissante, et elle retraverse le cristal liquide.

Dans un afficheur transmissif, il faut donc que l'électrode de pixel soit transparente (en ITO). Mais alors le transistor est exposé à la lumière, ce qui engendre des risques de fuites importantes et variables en fonction de l'éclairement du pixel. Ces fuites empêchent un maintien capacitif correct de la tension appliquée au pixel lors de l'écriture, alors que cette tension devrait subsister pendant tout le temps d'une trame suivant l'instant d'écriture.

Par ailleurs, dans un afficheur en technologie LCOS sur un substrat de silicium monocristallin, les dimensions des pixels sont très petites ce qui rend difficile la mise en place de capacités de valeur suffisante dans chaque pixel.

C'est pourquoi on propose un afficheur à cristal liquide de type transmissif selon la revendication 1.

La capacité est alors située du côté amont (dans le sens de l'éclairement) de l'empilement constitué par le cristal liquide, le transistor de commande et la capacité de stockage auxiliaire. En utilisation, la source de lumière de l'afficheur éclaire donc la capacité mais ne peut pas ou presque pas éclairer le transistor. Celui-ci est masqué par la capacité.

Le reste du pixel n'est pas masqué par la capacité et la lumière peut atteindre le cristal liquide (à travers l'électrode transparente) là où la capacité n'y fait pas obstacle.

Le transistor et la capacité de stockage auxiliaire occupent une petite partie, inférieure à 50% et la plus faible possible, de la surface du pixel. L'encombrement latéral de la capacité doit en effet être minimisé pour que l'ouverture du pixel, c'est-à-dire le rapport entre la surface de pixel qui laisse passer la lumière et la surface totale du pixel reste aussi élevée que possible.

Pour obtenir une capacité de stockage auxiliaire aussi élevée que possible dans un encombrement latéral aussi faible que possible, la capacité est réalisée par un empilement d'au moins deux structures à armatures interdigitées, chaque structure étant réalisée dans un niveau de métallisation opaque respectif. Les métallisations sont de préférence en aluminium et/ou en cuivre. Les structures interdigitées sont séparées par des couches isolantes et sont reliées entre elles par des vias conducteurs.

Par exemple, dans un afficheur à six niveaux de métallisation, on peut prévoir que quatre niveaux superposés servent à réaliser quatre structures à armatures interdigitées ayant chacun deux armatures ; les armatures correspondantes des différents niveaux sont toutes reliées entre elles par des vias. Les directions des doigts de deux structures interdigitées de deux niveaux différents sont alternées (perpendiculaires entre elles) pour mieux masquer la lumière.

Dans une réalisation, la capacité comporte en outre une armature qui occupe une surface continue opaque recouvrant la totalité du transistor.

Une capacité de compensation peut par ailleurs être réalisée dans le même empilement de couches métalliques que la capacité de stockage auxiliaire. Cette capacité est reliée électriquement entre l'électrode de pixel et une ligne conductrice permettant d'appliquer une tension de compensation. Cette capacité contribue à la protection du transistor contre la lumière et elle peut avoir une armature continue opaque recouvrant la totalité du transistor.

Le transistor et la capacité de stockage auxiliaire sont de préférence réalisés sur la couche superficielle monocristalline d'un substrat de silicium sur isolant (SOI).

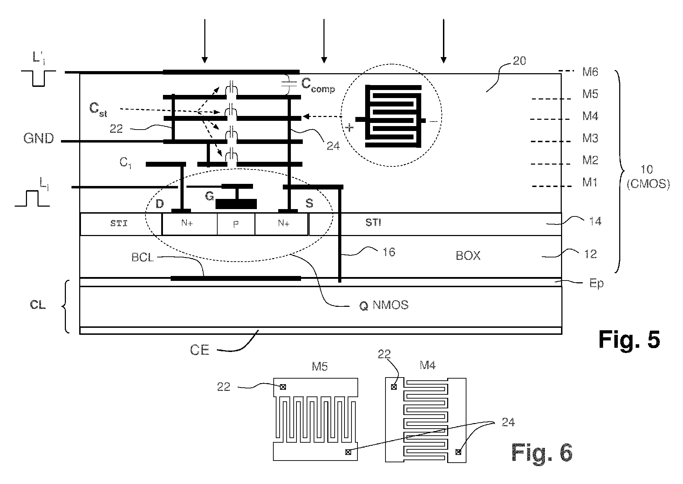

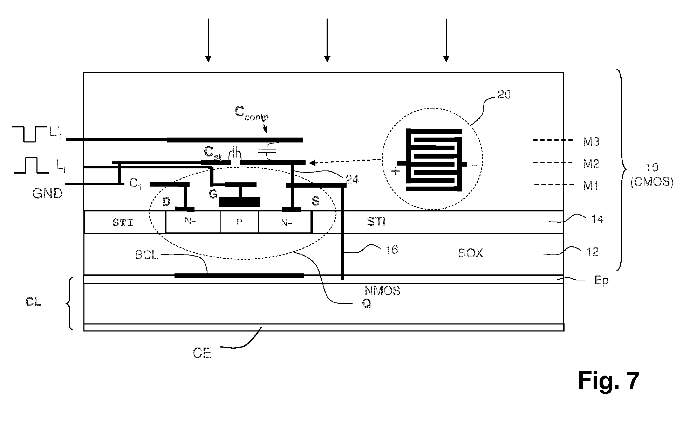

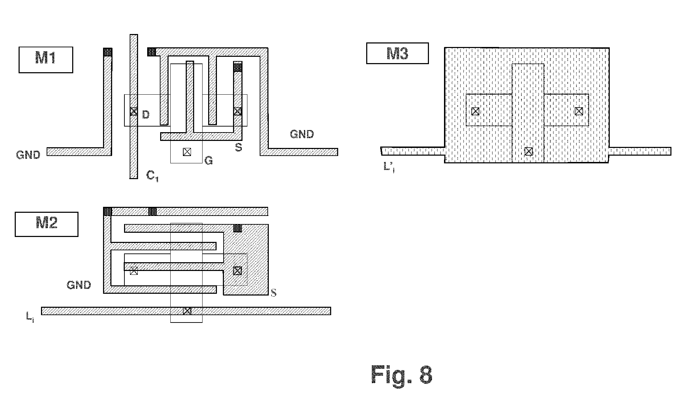

D'autres caractéristiques et avantages de l'invention apparaîtront à la lecture de la description détaillée qui suit et qui est faite en référence aux dessins annexés dans lesquels :- la figure 1 représente la structure d'un afficheur matriciel à cristaux liquides ; - la figure 2 représente un schéma électrique équivalent avec une capacité de stockage auxiliaire dans chaque pixel, raccordée à la ligne suivante ; - la figure 3 représente un autre schéma avec une capacité de stockage auxiliaire, raccordée à un conducteur de ligne auxiliaire, avec éventuellement une capacité de compensation raccordée à un conducteur de commande ; - la figure 4 représente un exemple de structure classique de pixel d'un afficheur à matrice active en silicium amorphe ; - la figure 5 représente le schéma en coupe d'une structure de pixel selon l'invention en technologie LCOS de type transmissif ; - la figure 6 représente schématiquement deux structures capacitives interdigitées ayant des doigts orientés selon des directions croisées, utilisées dans l'invention ; - la figure 7 représente un schéma en coupe d'une autre structure de pixel, utilisant trois niveaux de métallisation ; - la figure 8 représente en vue de dessus un exemple de motif de gravure de la métallisation pour chacun des trois niveaux de la figure 7.

L'afficheur à cristal liquide de type transmissif comprend une matrice de lignes et colonnes de pixels organisée par exemple comme sur l'un des schémas décrits aux figures 1 à 3 ; seul un pixel est représenté sur la coupe de la figure 5 ; chaque pixel comprend une cellule de cristal liquide CL entre une électrode de pixel Ep et une contre-électrode CE commune à tous les pixels ; le transistor de commande Q est réalisé dans une structure 10 de technologie CMOS, à base de silicium monocristallin, accolée à la cellule de cristal liquide. L'électrode commune CE et l'électrode de pixel Ep sont transparentes (en ITO), mais un bouclier opaque BCL (en aluminium par exemple) est localement interposé entre l'électrode de pixel et le transistor, pour protéger le transistor contre la lumière qui pourrait arriver par la cellule de cristal liquide par des phénomènes de réflexion.

Différentes technologies de fabrication existent pour la structure CMOS 10. Dans la technologie représentée à titre d'exemple, la structure 10 est formée à partir d'un substrat de silicium dit SOI (Silicon on Insulator, pour "silicium sur isolant") ; ce substrat comprend une superposition d'une couche isolante 12 d'oxyde de silicium adjacente à l'électrode de pixel Ep, et d'une couche de silicium monocristallin 14 dans laquelle est formé le transistor de commande. Le transistor représenté est un transistor NMOS comprenant une source et un drain dopés de type N+, séparés par un canal de type P recouvert par une grille isolée G, en silicium polycristallin ; le transistor pourrait alternativement être un transistor PMOS. Le transistor est séparé des transistors des pixels adjacents par de l'oxyde de silicium en tranchées isolantes superficielle (STI pour "shallow trench insulation").

Le transistor est recouvert par une alternance de couches isolantes et métalliques permettant de former les interconnexions nécessaires pour établir le schéma électrique de la matrice de pixels, et permettant de former la capacité de stockage auxiliaire Cₛₜ et éventuellement la capacité de compensation C_{comp}. Les couches métalliques sont reliées les unes aux autres et reliées au transistor par des vias conducteurs à travers les couches isolantes. Un via conducteur 16 formé dans la couche isolante 12 permet par ailleurs d'établir une connexion entre la source du transistor et l'électrode de pixel Ep.

Les couches métalliques sont de préférence en aluminium et/ou en cuivre. Elles sont opaques à la lumière, et plus particulièrement opaques à la lumière d'une source lumineuse (non représentée) de l'afficheur, placée au-dessus de l'empilement représenté.

Le transistor occupe une faible partie de la surface du pixel (de la même manière qu'on voyait un transistor occupant une faible partie de la surface du pixel dans la technologie en silicium amorphe de la figure 4), et c'est cette partie du pixel qui est principalement représentée sur la figure 5.

Dans l'exemple représenté sur la figure 5, il y a six niveaux de métallisation superposés, désignés respectivement par les références M1 à M6. Le nombre de niveaux pourrait être différent. L'attribution des fonctions des différents niveaux peut varier et on en donnera simplement un exemple, mais dans tous les cas ils servent à réaliser la capacité de stockage Cₛₜ et éventuellement la capacité de compensation C_{comp}; ils forment par ailleurs toutes les interconnexions internes au pixel et les interconnexions (lignes de commande, lignes de masse, conducteurs de colonnes, etc. nécessaire au fonctionnement de la matrice. Les niveaux métalliques sont représentés symboliquement par des traits horizontaux épais, et les vias sont représentés symboliquement par des traits verticaux épais ; les couches isolantes (en oxyde de silicium) qui séparent les niveaux sont déposées successivement entre les niveaux métalliques successivement déposés mais elles sont représentées comme une seule couche isolante 20 dans laquelle sont noyés les niveaux métalliques.

Dans l'exemple de la figure 5 :
- le niveau M1 sert à deux fonctions : réaliser le conducteur de ligne Lᵢ, relié par un via à la grille du transistor, et en même temps réaliser une connexion entre la source du transistor et l'électrode de pixel en utilisant le via 16 ;
- le niveau M2 sert à réaliser le conducteur de colonne C₁ auquel est relié le pixel, relié par un via au drain du transistor, et en même temps à réaliser une partie de la capacité de stockage auxiliaire Cₛₜ ;
- le niveau M3 sert à réaliser une connexion vers une masse commune à toute la matrice, et en même temps à réaliser une autre partie de la capacité de stockage auxiliaire Cₛₜ ;
- les niveaux M4 et M5 servent à réaliser encore une partie de la capacité de stockage auxiliaire Cₛₜ ;
- et enfin, le niveau M6 sert à réaliser dans cet exemple une armature de la capacité de compensation C_{comp} si la capacité de compensation est différente de la capacité de stockage, ou alors encore une partie de la capacité de stockage auxiliaire Cst s'il n'y a pas de capacité de compensation ; le niveau M6 sert aussi à constituer le conducteur de ligne de compensation L'; si le schéma est celui de la figure 3 ; l'armature de capacité réalisée dans le dernier niveau M6 de l'empilement est de préférence une surface métallique (opaque) continue recouvrant l'ensemble des portions métalliques qui servent à réaliser la capacité de stockage Cst.

La répartition des conducteurs dans les différents niveaux métalliques peut être différente de celle qui a été indiquée ci-dessus : le niveau M1 plutôt que le niveau M3 peut servir par exemple à réaliser des lignes de connexion reliées à la masse ; le niveau M3 peut servir à réaliser la connexion L'; pour la capacité de compensation et la capacité de compensation elle-même s'il y en a une ; etc.

La capacité de stockage auxiliaire Cst recouvre entièrement le transistor et empêche en grande partie la lumière de pénétrer jusqu'à lui ; le barrage contre la lumière est d'autant meilleur qu'il y a un plus grand nombre de niveaux métalliques au-dessus du transistor. Le bouclier opaque BCL protège également le transistor de la lumière susceptible d'arriver par- dessous.

Pour maximiser la valeur de la capacité de stockage tout en limitant son encombrement latéral, on prévoit qu'elle est réalisée à partir d'une structure à armatures interdigitées, et on prévoit qu'elle est réalisée à partir de la surperposition de plusieurs structures à armatures interdigitées connectées électriquement en parallèle.

Chacun des niveaux M2 à M5, dans le cas représenté à titre d'exemple, comporte une capacité partielle à armatures interdigitées, c'est-à-dire que les deux armatures de la capacité partielle sont formées dans un même niveau métallique. Chaque armature comprend une série de conducteurs (ou doigts de la structure) reliés électriquement entre eux, géographiquement proches des conducteurs d'une autre série de conducteurs appartenant à l'autre armature. La couche isolante 20 dans laquelle sont noyés les niveaux métalliques constitue le diélectrique entre les doigts appartenant à deux armatures. Le dessin entouré d'un cercle tireté est une vue de principe en plan de l'allure générale d'une telle capacité partielle dans le niveau M4 ; les autres niveaux sont réalisés de manière similaire. Le dessin représente des doigts parallèles pour les deux armatures, mais en pratique le dessin précis des armatures dépend de la place disponible dans chaque niveau compte-tenu des interconnexions à réaliser, et notamment compte-tenu des contraintes liées aux vias de contact à réaliser entre les niveaux de métallisation.

Des vias conducteurs tels que 22 et 24 connectent les armatures correspondantes entre les différents niveaux, de sorte que la superposition des niveaux forme des capacités partielles en parallèle.

Les doigts des armatures interdigitées sont orientés de manière croisée d'un niveau à l'autre, pour mieux empêcher la lumière de passer. La figure 6 montre cette orientation croisée, dans une configuration simpliste où les doigts sont tous parallèles et rectilignes. Dans la réalité, les doigts des armatures des capacités peuvent avoir des formes plus tordues.

On ajoutera que si les peignes correspondant à deux niveaux non adjacents (tels que M3 et M5 par exemple) ont des doigts parallèles, on peut encore essayer de placer les doigts de l'un regard des intervalles entre doigts de l'autre, encore dans le but de limiter la pénétration de lumière.

On comprendra que la capacité formée par des structures interdigitées peut être plus élevée que la capacité entre deux couches métalliques successives séparées par une couche isolante. En effet, la capacité résulte de la mise en regard sur toute leur longueur des doigts des structures. Les doigts sont allongés, ils peuvent être nombreux, et leur largeur et leur espacement peuvent être de quelques micromètres.

Enfin, les vias conducteurs entre les différents niveaux de métallisation contribuent à la protection du transistor contre la lumière : ils tendent à piéger la lumière qui se propage latéralement ; on aura donc avantage à prévoir plusieurs vias plutôt qu'un seul pour connecter deux éléments conducteurs qui doivent être reliés électriquement.

Dans l'exemple de la figure 5, la capacité de compensation comprend une armature continue opaque, mais on comprendra qu'on peut prévoir alternativement que c'est la capacité de stockage Cst (ou les deux capacités) qui possède une armature continue opaque.

La figure 7 représente un autre exemple de structure de pixel. Dans cet exemple on n'utilise que trois niveaux de métallisation M1, M2 et M3 ; on peut avoir intérêt en effet, pour des raisons de coût de fabrication, à minimiser le nombre de niveaux de métallisation ; l'efficacité de la protection contre la lumière diminue cependant ; en pratique il y aura au moins trois niveaux de métallisation et l'exemple de la figure 7 comprend :
- le niveau M1 sert à réaliser une connexion entre la source du transistor et l'électrode de pixel en utilisant le via 16 ; il sert aussi à réaliser le conducteur de colonne C₁ auquel est relié le pixel, relié par un via au drain du transistor ; il sert à réaliser un conducteur de masse GND ; et enfin, il peut servir à former une capacité interdigitée qui constitue une partie de la capacité de stockage Cₛₜ ;
- le niveau M2 sert à réaliser le conducteur de ligne Li et une autre partie (interdigitée) de la capacité de stockage Cₛₜ, connectée en parallèle avec la partie de capacité formée dans le niveau M1 ;
- et enfin, le niveau M3 sert à réaliser dans cet exemple une armature de la capacité de compensation C_{comp} si la capacité de compensation est différente de la capacité de stockage, ou alors encore une partie de la capacité de stockage auxiliaire Cₛₜ s'il n'y a pas de capacité de compensation ; le niveau M3 sert aussi à constituer le conducteur de ligne de compensation L'ᵢ si le schéma est celui de la figure 3 ; l'armature de capacité réalisée dans le dernier niveau M3 de l'empilement est de préférence une surface métallique (opaque) continue recouvrant l'ensemble des portions métalliques qui servent à réaliser la capacité de stockage Cₛₜ ; l'autre armature de la capacité C_{comp} est constituée par une des armatures de la capacité de stockage interdigitée du niveau M2.

La figure 8 représente une configuration possible des trois niveaux métalliques M1, M2, M3 pour former les éléments indiqués ci-dessus. On y voit les vias de connexion entre les niveaux, représentés par des zones hachurées plus denses, ainsi que les vias de connexion avec la source, la grille et le drain du transistor.

La capacité de stockage auxiliaire Cₛₜ recouvre le transistor et empêche en grande partie la lumière de pénétrer jusqu'à lui ; le barrage contre la lumière est d'autant meilleur qu'il y a un plus grand nombre de niveaux métalliques au-dessus du transistor.

Dans la configuration de la figure 8, c'est la capacité de compensation C_{comp} qui possède une armature continue opaque recouvrant la totalité du transistor pour mieux le protéger de la lumière. L'ensemble de la capacité de stockage et de la capacité de compensation offrent donc une très bonne protection du transistor contre un éclairement par la source de lumière de l'afficheur transmissif.

## Revendications

1. Afficheur à cristal liquide de type transmissif comprenant une matrice de lignes et colonnes de pixels, chaque pixel comprenant un cristal liquide CL entre une électrode de pixel (EP) transparente et une contre-électrode (CE) transparente commune à tous les pixels, un transistor de commande (Q) et une capacité de stockage auxiliaire (Cₛ), la grille du transistor étant reliée à un premier conducteur de ligne (Lᵢ) commun à tous les pixels d'une même ligne pour recevoir de ce conducteur une impulsion de commande d'écriture, le drain du transistor étant relié à un conducteur de colonne (C₁) commun à tous les pixels d'une même colonne pour en recevoir une tension analogique représentant un niveau de gris à afficher, et la source du transistor étant reliée à l'électrode du pixel et à une borne de la capacité de stockage auxiliaire, et le transistor étant situé entre le cristal liquide et la capacité de stockage auxiliaire, **caractérisé en ce que** l'afficheur est réalisé en technologie LCOS, la capacité étant réalisée par un empilement d'au moins deux structures en métal opaque à armatures interdigitées superposées et mises en parallèle par des vias conducteurs, chaque structure étant réalisée dans un niveau de métallisation respectif (M2 à M5), et les structures à armatures interdigitées comprenant des doigts parallèles dans chaque structure, les doigts d'une structure étant perpendiculaires aux doigts de l'autre structure, le transistor et la capacité de stockage occupant une surface inférieure à 50% de la surface du pixel.

2. Afficheur selon la revendication 1, **caractérisé en ce que** la capacité est réalisée dans un empilement d'au moins trois niveaux de métallisation séparés par des couches isolantes, avec des vias conducteurs (22, 24) pour relier entre eux les différents niveaux en fonction des interconnexions à établir.

3. Afficheur selon l'une des revendications 1 à 2, **caractérisé en ce que** la capacité de stockage auxiliaire comporte en outre une armature constituant une surface continue opaque recouvrant la totalité du transistor.

4. Afficheur selon l'une des revendications 1 à 3, **caractérisé en ce qu'**il comporte en outre une capacité dite de compensation C_{comp} reliée à un conducteur de ligne auxiliaire (L'ᵢ) reliant tous les pixels de la même ligne, la capacité de compensation étant située au-dessus du transistor.

5. Afficheur selon la revendication 4, **caractérisé en ce que** la capacité de compensation comporte une armature avec une surface continue opaque recouvrant la totalité du transistor.

6. Afficheur selon l'une des revendications 1 à 5, **caractérisé en ce que** le transistor et la capacité de stockage auxiliaire sont réalisés sur la couche superficielle monocristalline d'un substrat de silicium monocristallin sur isolant (SOI).

## Patentansprüche

1. Flüssigkristallanzeige des transmissiven Typs, die Folgendes umfasst: eine Matrix von Pixelreihen und -spalten, wobei jedes Pixel einen Flüssigkristall CL zwischen einer transparenten Pixelelektrode (EP) und einer transparenten Gegenelektrode (CE) umfasst, die allen Pixeln gemeinsam ist, einen Steuertransistor (Q) und einen zusätzlichen Speicherkondensator (Cₛ), wobei das Gate des Transistors mit einem ersten Reihenleiter (Lᵢ) verbunden ist, der allen Pixeln einer selben Reihe gemeinsam ist, um von diesem Leiter einen Schreibsteuerimpuls zu empfangen, wobei der Drain des Transistors mit einem Spaltenleiter (C₁) verbunden ist, der allen Pixeln einer selben Spalte gemeinsam ist, um davon eine analoge Spannung zu empfangen, die eine anzuzeigende Graustufe repräsentiert, und wobei die Source des Transistors mit der Elektrode des Pixels und mit einem Anschluss des zusätzlichen Speicherkondensators verbunden ist, und wobei sich der Transistor zwischen dem Flüssigkristall und dem zusätzlichen Speicherkondensator befindet, **dadurch gekennzeichnet, dass** die Anzeige in LCOS-Technologie realisiert ist, wobei der Kondensator durch einen Stapel von wenigstens zwei opaken Metallstrukturen mit überlagerten interdigitalen Ankern realisiert und durch leitende Durchkontaktierungen parallelgeschaltet ist, wobei jede Struktur in einem jeweiligen Metallisierungsniveau (M2 bis M5) realisiert ist und die interdigitalen Ankerstrukturen parallele Finger in jeder Struktur umfassen, wobei die Finger einer Struktur lotrecht zu den Fingern der anderen Struktur sind, wobei der Transistor und der Speicherkondensator eine Fläche von weniger als 50 % der Oberfläche des Pixels einnehmen.

2. Anzeige nach Anspruch 1, **dadurch gekennzeichnet, dass** der Kondensator in einem Stapel von wenigstens drei durch Isolierschichten getrennten Metallisierungsniveaus realisiert ist, mit leitenden Durchkontaktierungen (22, 24), um die verschiedenen Niveaus in Abhängigkeit von herzustellenden Verbindungen miteinander zu verbinden.

3. Anzeige nach einem der Ansprüche 1 bis 2, **dadurch gekennzeichnet, dass** der zusätzliche Speicherkondensator darüber hinaus einen Anker umfasst, der eine opake kontinuierliche Fläche bildet, die die Gesamtheit des Transistors bedeckt.

4. Anzeige nach einem der Ansprüche 1 bis 3, **dadurch gekennzeichnet, dass** sie darüber hinaus einen so genannten Kompensationskondensator C_{comp} umfasst, der mit einem zusätzlichen Reihenleiter (L'ᵢ) verbunden ist, der alle Pixel derselben Reihe verbindet, wobei sich der Kompensationskondensator über dem Transistor befindet.

5. Anzeige nach Anspruch 4, **dadurch gekennzeichnet, dass** der Kompensationskondensator einen Anker mit einer opaken kontinuierlichen Fläche umfasst, die die Gesamtheit des Transistors bedeckt.

6. Anzeige nach einem der Ansprüche 1 bis 5, **dadurch gekennzeichnet, dass** der Transistor und der zusätzliche Speicherkondensator auf der monokristallinen Oberflächenschicht eines monokristallinen Siliciumsubstrats auf einem Isolator (SOI) realisiert sind.

## Claims

1. A transmissive liquid-crystal display comprising a matrix of rows and columns of pixels, each pixel comprising a liquid crystal (CL) between a transparent pixel electrode (Ep) and a transparent counter electrode (CE) common to all the pixels, a drive transistor (Q) and an auxiliary storage capacitor (Cₛₜ), the gate of the transistor being connected to a first row conductor (Lᵢ) common to all the pixels of a given row so as to receive from this conductor a write control pulse, the drain of the transistor being connected to a column conductor (C₁) common to all the pixels of a given column so as to receive therefrom an analog voltage representing a grayscale to be displayed, and the source of the transistor being connected to the electrode of the pixel and to a terminal of the auxiliary storage capacitor, and the transistor being located between the liquid crystal and the auxiliary storage capacitor, **characterized in that** the display is made in LCOS technology, the capacitor consisting of a stack of at least two structures made of opaque metal having interdigitated parallel electrodes, the structures being superposed and placed in parallel by means of conductive vias, each structure being produced in a respective metallization level (M2 to M5), and each of the interdigitated-electrode structures comprising parallel fingers, the fingers of one structure being perpendicular to the fingers of the other structure, the transistor and the storage capacitor occupying an area smaller than 50% of the area of the pixel.

2. The display as claimed in claim 1, **characterized in that** the capacitor consists of a stack of at least three metallization levels separated by insulating layers, with conductive vias (22, 24) connecting the various levels depending on the interconnections to be made.

3. The display as claimed in one of claims 1 to 2, **characterized in that** the auxiliary storage capacitor additionally comprises an electrode that forms a continuous opaque area that covers the entire transistor.

4. The display as claimed in one of claims 1 to 4, **characterized in that** it further comprises a so-called compensation capacitor C_{comp} connected to an auxiliary row conductor (L'ᵢ) connecting all the pixels in a given row, the compensation capacitor being located above the transistor.

5. The display as claimed in claim 4, **characterized in that** the compensation capacitor comprises an electrode having a continuous opaque area that covers the entire transistor.

6. The display as claimed in one of claims 1 to 5, **characterized in that** the transistor and the auxiliary storage capacitor are produced on the single-crystal surface layer of a single-crystal-silicon-on-insulator (SOI) substrate.
